Europäisches Patentamt

European Patent Office

Office européen des brevets

(11) Veröffentlichungsnummer : **0 014 724**
**B1**

(12) # EUROPÄISCHE PATENTSCHRIFT

(45) Veröffentlichungstag der Patentschrift :
30.03.83

(51) Int. Cl.³ : **H 03 J   1/02, H 04 B   1/28**

(21) Anmeldenummer : **79100502.8**

(22) Anmeldetag : **21.02.79**

(54) **Automatische Abstimmschaltung mit einer Regelschleife für einen Hochfrequenz-Überlagerungsempfänger.**

(43) Veröffentlichungstag der Anmeldung :
**03.09.80 Patentblatt 80/18**

(45) Bekanntmachung des Hinweises auf die Patenterteilung : **30.03.83 Patentblatt 83/13**

(84) Benannte Vertragsstaaten :
**BE CH FR GB IT**

(56) Entgegenhaltungen :
DE A 2 738 802

**FUNKSCHAU, Jahrgang 48, Nr. 9, April 1976 München, DE. KLANK et al. : « Digitale Frequenz-Kanal- und Zeitanzeige in einem Spitzen-Receiver », Seiten 334-337**
**GRUNDIG TECHNISCHE INFORMATIONEN, Jahrgang 25, Nr. 5, 1978 Fürth, DE. SCHOLZ : « Digitale Frequenz- und Kanalanzeige », Seiten 288-290**
**RADIO MENTOR ELECTRONIC, Jahrgang 41, No. 9, 1975 Berlin, DE. C.R. : « Digitalskala für Hi-Fi Tuner », Seiten 360-361**

(73) Patentinhaber : **Licentia Patent-Verwaltungs-GmbH Theodor-Stern-Kai 1**
**D-6000 Frankfurt/Main 70 (DE)**

(72) Erfinder : **Klank, Otto, Ing.-grad.**
**Marienburgstrasse 12**
**D-3161 Arpke (DE)**

(74) Vertreter : **Einsel, Robert, Dipl.-Ing.**
**Licentia Patent-Verwaltungs-GmbH Theodor-Stern-Kai 1**
**D-6000 Frankfurt/Main 70 (DE)**

## Automatische Abstimmschaltung mit einer Regelschleife für einen Hochfrequenz- Überlagerungsempfänger

Es sind Abstimmschaltungen mit digitaler Frequenz-Eingabe bekannt (z. B. « Funkschau » 1974, Heft 2, Seite 62 ff. und Heft 3, Seite 93 ff.), bei denen die Empfangsfrequenz durch Zählen der Schwingungen des Überlagerungsoszillators unter Berücksichtigung der Zwischenfrequenz bestimmt wird. Das Zählergebnis wird in einem Vergleicher mit einem in einen Eingabespeicher eingegebenen Wert verglichen. Von einer Auswerteschaltung wird in Abhängigkeit von dem Vergleichsergebnis der Abstimmvorgang gesteuert.

Die Erfindung geht aus von einer solchen automatischen Abstimmschaltung nach dem Oberbegriff des Anspruchs 1.

Der Erfindung liegt die Aufgabe zugrunde, eine derartige Abstimmschaltung so zu erweitern, daß wahlweise die Empfangsfrequenz oder die Kanalzahl angezeigt werden kann. Es soll ein Wechsel zu einem beliebigen Zeitpunkt auch nach einer erfolgten Eingabe möglich sein, ohne daß die Funktion der Schaltung dadurch beeinträchtigt wird. Für den Bedienenden ist es eine Erleichterung, wenn er einerseits zwischen den beiden Möglichkeiten der Eingabe wechseln kann, weil er unter Umständen in einem Fall nur die Frequenz des gewünschten Senders und in einem anderen Fall nur die Kanalzahl kennt, und wenn er andererseits feststellen kann, welche Frequenz ein durch eine Kanalzahl eingegebener Sender hat, bzw. umgekehrt.

Diese Aufgabe wird durch die im Anspruch 1 angegebene Erfindung gelöst.

In den Unteransprüchen sind vorteilhafte Ausführungsformen der Erfindung angegeben.

Im Folgenden wird die Erfindung anhand eines in der Zeichnung dargestellten Ausführungsbeispieles näher erläutert. Es zeigen :

Figur 1 ein Blockschaltbild zur Erläuterung der Funktion der erfindungsgemäßen Schaltung,

Figur 2 ein Ausführungsbeispiel für eine bei der Erfindung anwendbare Steuerschaltung,

Figur 3 eine Darstellung zur Erläuterung von in Fig. 2 verwendeten Symbolen,

Figur 4 eine Tabelle zum Steuerungsablauf der Schaltung gemäß Fig. 2,

Figur 5 ein Zeitdiagramm des Steuerungsablaufes der Schaltung gemäß Fig. 2 und

Figur 6 ein Schaltungsdetail der Schaltung nach Fig. 2.

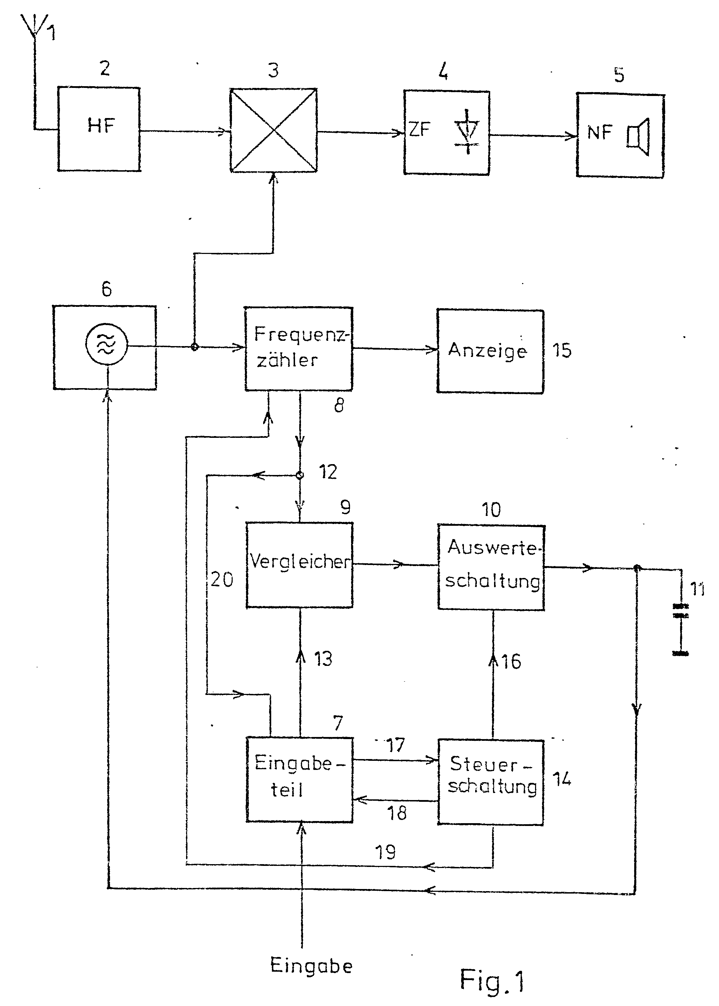

In Fig. 1 ist oben ein Überlagerungsempfänger mit einer Antenne 1, einer HF-Vorstufe 2, einer Mischstufe 3, einem ZF-Verstärker und Demodulator 4 und einem NF-Verstärker und Lautsprecher 5 dargestellt. Der Mischstufe 3 ist das Ausgangssignal eines Überlagerungsoszillators 6 zugeführt, der Bestandteil einer in Fig. 1 unten dargestellten Abstimmschaltung ist. Die Abstimmschaltung enthält einen Eingabeteil 7, in den ein der gewünschten Empfangsfrequenz zugeordneter Wert über eine nicht dargestellte Eingabetastatur oder ein gespeicherter Wert eingegeben werden kann, und einen elektronischen Frequenzzähler 8, mit dem die Empfangsfrequenz oder der Empfangskanal durch Zählen der Schwingungen des Überlagerungsoszillators 6 unter Berücksichtigung der ZF « gemessen » wird.

Der Inhalt eines im Eingabeteil 7 enthaltenen Eingabespeichers und das Meßergebnis des Frequenzzählers 8 werden in einem Vergleicher 9 miteinander verglichen. Bei der bekannten Schaltung gemäß « Funkschau » 1974, Heft 2, Seite 62 ff. erfolgt der Vergleich aller Stellen gleichzeitig. Es ist jedoch auch bekannt (DE-A-25 33 072.7), die einander zugeordneten Stellen zeitlich nacheinander im sogenannten Zeit-Multiplexbetrieb durchzuführen. Im folgenden sei angenommen, daß der Vergleich, wie in der genannten Offenlegungsschrift beschrieben, im Multiplexbetrieb stattfindet. Jedoch ist die Erfindung nicht auf diese Art des Vergleiches beschränkt. Sie ist auch bei einer Abstimmschaltung anwendbar, bei der der Vergleich nicht im Multiplexbetrieb durchgeführt wird.

An den Ausgang des Vergleichers 9 ist eine Auswerteschaltung 10 angeschlossen, mittels der der Ladestrom eines Kondensators 11 in Abhängigkeit von dem Vergleichsergebnis des Vergleichers 9 gesteuert wird. Die Ladespannung am Kondensator 11 ist dem Oszillator 6 als Abstimmspannung zugeführt. Damit ist die Regelschleife, durch die die Empfangsfrequenz auf den eingegebenen Wert eingeregelt wird, geschlossen. Der Aufbau und die Funktion einer bei der dargestellten Schaltung anwendbaren Auswerteschaltung 10 ist in der DE-A-25 33 072.7 ausführlich beschrieben.

Für den Frequenzzähler 8 kann die bekannte integrierte Schaltung AY-5-8 100 des Herstellers General Instrument verwendet werden. Von dieser integrierten Schaltung können die für die Steuerung des Vergleiches erforderlichen Signale mittels einer Schaltung, die in der DE-A-25 56 486.7 beschrieben ist, direkt abgeleitet werden. Da die Schaltungsdetails aus den genannten Offenlegungsschriften im einzelnen bekannt sind werden nur die für das Verständnis der Erfindung wichtigen Verbindungen zwischen den einzelnen dargestellten Blöcken beschrieben. Das in dem Frequenzzähler 8 gewonnene Zählergebnis wird über eine Verbindung 12 stellenweise nacheinander zum Vergleicher 9 übertragen. Im Eingabeteil 7 befindet sich ein Umlaufspeicher der synchron zu dem Multiplexbetrieb des Frequenzzählers 8 angesteuert ist. In den Umlaufspeicher kann ein Empfangsfrequenz-Wert eines gewünschten Senders oder die zugeordnete Kanalzahl eingegeben werden. Je nach der verwendeten Eingabeart und dem zu dem eingegebenen Wert gehörigen Empfangsbereich werden in der für den Frequenzzähler 8 verwendeten integrierten Schaltung die erforderlichen Umschaltungen vor-

genommen, so daß im Vergleicher 9 einander entsprechende Größen verglichen werden. Der Inhalt des Umlaufspeichers wird über die Verbindung 13 zum Vergleicher 9 übertragen.

Das Zählergebnis des Frequenzzählers 8 wird in einer Anzeigeeinrichtung 15 angezeigt. In dem Frequenzzähler kann im UKW-Bereich zwischen zwei Betriebsarten umgeschaltet werden. Bei der einen Betriebsart wird die Empfangsfrequenz des empfangenen Senders durch Zählen der Oszillatorschwingungen des Überlagerungsoszillators 6 bestimmt und in der anderen Betriebsart der Empfangskanal dieses Senders. Entsprechend wird von der Anzeigeeinrichtung 15 die Frequenz oder der Kanal des empfangenen Senders angezeigt. Die Funktion der soweit beschriebenen Schaltung würde jedoch gestört, wenn nur diese Umschaltung durchgeführt würde, da dem Vergleicher verschiedenartige Werte, z. B. vom Frequenzzähler der Empfangskanal und vom Eingabeteil 7 die Empfangsfrequenz, zugeführt würden. Die Abstimmeinstellung würde dadurch verloren gehen. Damit die Umschaltung trotzdem möglich ist, ist bei der Erfindung eine in Fig. 1 mit 14 bezeichnete Steuerschaltung vorgesehen, mittels der nach einer Umschaltung des Frequenzzählers 8 von einer Betriebsart in die andere Betriebsart nach wenigstens einem Zählzyklus des Frequenzzählers in der neuen Betriebsart eine Übernahme des geänderten Zählergebnisses in den Eingabespeicher gesteuert wird. Nach dieser Übernahme werden dem Vergleicher wieder gleichartige Größen zugeführt, so daß die Abstimmeinstellung erhalten bleibt.

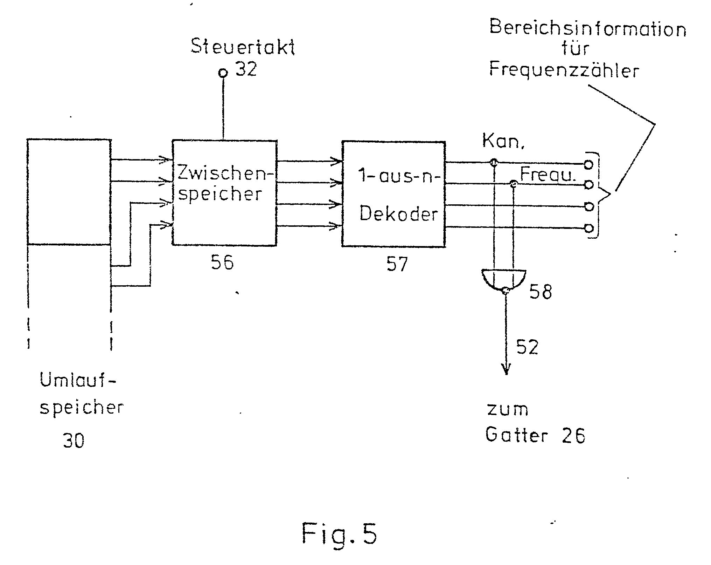

Es kann vorteilhaft sein, während der Zeit der Übernahme des neuen Zählergebnisses in den Eingabespeicher, der bei der dargestellten Schaltung als Umlaufspeicher ausgebildet ist, die Regelschleife der Abstimmschaltung zu sperren. Zu diesem Zweck ist die Steuerschaltung 14 über eine Verbindung 16 mit der Auswerteschaltung 10 verbunden. Durch ein zu der Auswerteschaltung 10 übertragenes Signal wird die Auswertung unterbrochen. Bei der in der DE-A-25 33 072.7 beschriebenen, bekannten Auswerteschaltung ist in einer Verbindungsleitung von dem dort entsprechend ausgebildeten Vergleicher, über die bei Gleichheit der verglichenen Stellen ein Gleichheitssignal übertragen wird, ein Inverter vorgesehen (Inverter 55 in Fig. 5 der DE-A-25 33 072.7). Dieser Inverter kann durch Hinzufügen eines zweiten Einganges zu einem NAND-Gatter erweitert werden. Dem zusätzlichen Eingang kann das Sperrsignal von der Steuerschaltung 14 zur Unterbrechung der Regelschleife zugeführt werden.

Zunächst erhält, wie durch Pfeil 17 angedeutet, die Steuerschaltung vom Eingabeteil die Information, daß innerhalb des gleichbleibenden Empfangsbereiches zwischen der Frequenz- und der Kanalanzeige umgeschaltet worden ist. Daraufhin wird über eine Verbindung 19 zum Frequenzzähler zunächst die entsprechende Umschaltung im Frequenzzähler 8 durchgeführt. Nach einer gewissen Wartezeit erscheint an der Verbindung 12 das Zählergebnis in der neuen Betriebsart. Dieses wird außer zum Vergleicher 9 auch über eine Verbindung 20 zu dem im Eingabeteil enthaltenen Umlaufspeicher übertragen. Sobald das neue Zählergebnis am Eingabeteil 7 vorliegt, erhält der Umlaufspeicher im Eingabeteil 7, wie durch Pfeil 18 angedeutet, von der Steuerschaltung 14 ein Steuersignal zur Übernahme des Zählergebnisses. Damit ist der Umschaltvorgang abgeschlossen und die Regelschleife kann wieder geöffnet werden. Der gesamte Steuervorgang erfordert so wenig Zeit, daß die Abstimmspannung am Kondensator 11, selbst wenn auf die beschriebene Sperrung der Regelschleife verzichtet würde, praktisch unverändert geblieben ist.

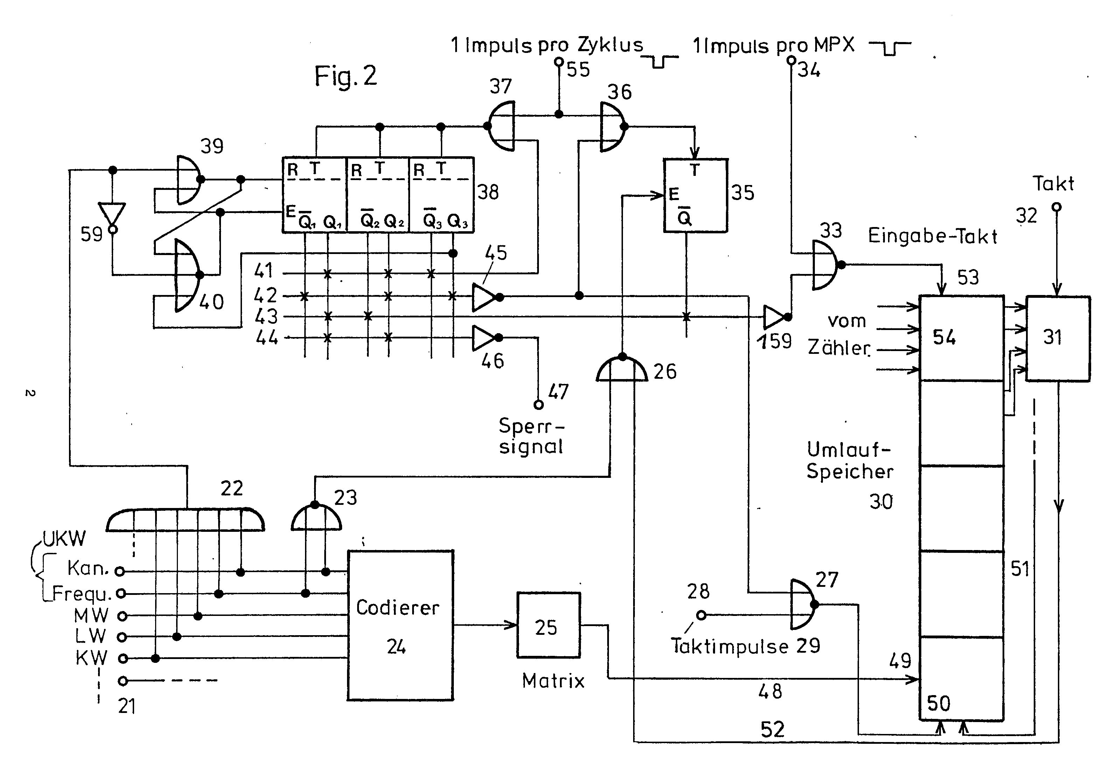

In Fig. 2 ist eine Steuerschaltung, die speziell an den Vergleich im Multiplexbetrieb angepaßt ist, und ein Teil des Eingabeteils 7 (Fig. 1) dargestellt. An links unten in Fig. 2 dargestellten Eingangsklemmen 21 wird durch Anlegen des logischen Pegels « 1 » an eine der Klemmen 21 der Empfangsbereich vorgegeben. Die Klemmen 21 können beispielsweise direkt mit Kontakten von Eingabetasten verbunden sein. Dem UKW-Bereich sind zwei der Eingangsklemmen 21 zugeordnet. Je nachdem, ob der Empfangskanal oder die Empfangsfrequenz angezeigt werden soll, wird die eine oder andere Klemme an das dem logischen Zustand « 1 » zugeordnete Potential gelegt.

Die so in den Empfänger eingegebene Bereichsinformation (Im Folgenden werden mit diesem Begriff alle über die Eingangsklemmen 21 eingegebenen Informationen verstanden) wird über einen Codierer 24 und eine Matrix 25, wie durch eine Verbindungslinie 48 angedeutet, zu einem Eingang 49 der untersten Stufe des Umlaufspeichers 30 übertragen. Für den Codierer 24 und die Matrix 25 kann eine in der schon genannten DE-A-25 33 072.7 beschriebene Schaltung verwendet werden. Die Aufnahme der am Eingang 49 als Binärzahl vorliegenden Bereichs-Information erfolgt parallel. Der Zeitpunkt der Übernahme wird über einen Steuereingang 50 gesteuert.

Die Eingabe des gewünschten Kanal- bzw. Empfangsfrequenz-Wertes in den Umlaufspeicher 30 und die Übertragung der Stellen des eingegebenen Wertes zum Vergleicher 9 in Fig. 1 erfolgt auf bekannte Weise (siehe DE-A 25 33 072.7) und ist hier nicht näher dargestellt. Die Bereichsinformation umfaßt insgesamt vier Bit. In zwei aufeinander folgenden Multiplexphasen des Umlaufspeichers werden je zwei Bit in zwei aufeinander folgende Stufen des Umlaufspeichers übernommen.

Die Eingangsklemmen 21, von denen in Fig. 2 sechs dargestellt sind, sind je mit einem Eingang eines ODER-Gatters 22, das eine der Zahl der Eingangsklemmen entsprechende Zahl von Eingängen aufweist, verbunden. Wenn eine der Eingangsklemmen 21 mit dem logischen Signal « 1 » verbunden wird, so erscheint am Ausgang des Gatters 22 ebenfalls ein logisches Signal « 1 ».

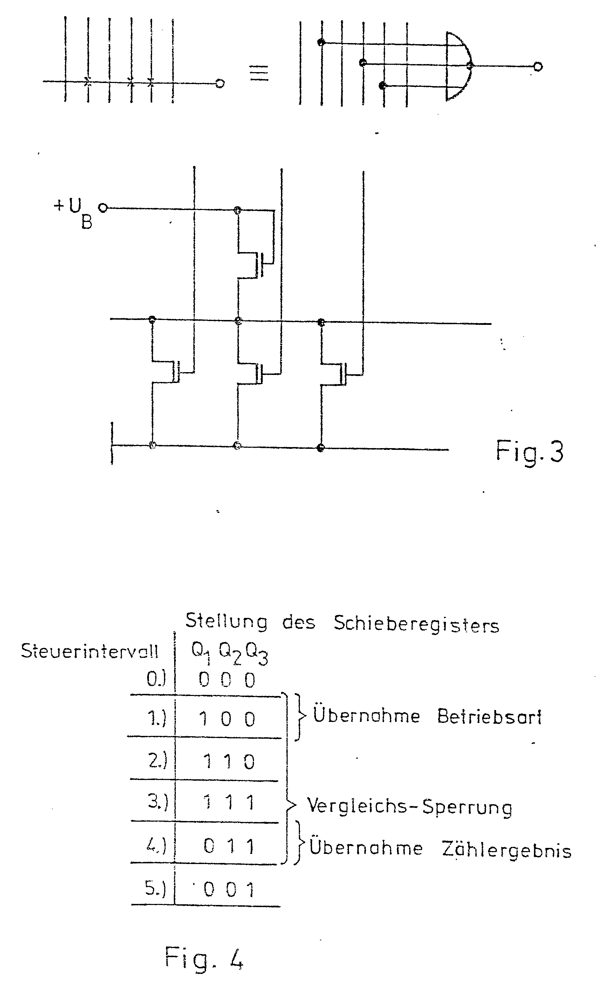

Dieses Signal wird zu einer oben links in Fig. 2 dargestellten Schaltungsanordnung übertragen, von der die für die Steuerung der Übernahme erforderlichen Signale erzeugt werden. Es ist ein dreistufiges Schieberegister 38 vorgesehen mit einem Eingang E und einem « Reset »-Eingang R. Vor die Eingänge des Schieberegisters 38 ist eine Schaltung aus zwei NOR-Gattern 39 und 40 und einem Inverter 59 geschaltet. Wenn der obere Eingang des NOR-Gatters 39 vom Gatter 22 das logische Signal « 1 » erhält, so steht am Ausgang des mit dem Reset-Eingang R verbundenen Gatters 39 das logische Signal « 0 » und am Ausgang des mit dem Eingang E verbundenen Gatters 40 das logische Signal « 1 ». Den Takteingängen T der Stufen des Schieberegisters 38 wird über ein zunächst geöffnetes ODER-Gatter 37 von einer Klemme 55 pro Umlaufzyklus des Umlaufspeichers 30 ein Impuls zugeführt. Bei der Ausgangsstellung « 0 » « 0 » « 0 » des Schieberegisters 38 beginnend werden mit jedem Taktimpuls die logischen Zustände der Stufen des Schieberegisters 38 um je eine Stufe weitergeschaltet. Wenn der logische Zustand « 1 » am Eingang E der ersten Stufe herrscht und der Reset-Eingang R auf logisch « 0 » steht, so erscheint nach dem ersten Taktimpuls, wie in Fig. 4 dargestellt, am Ausgang $Q_1$ eine logische « 1 », nach dem zweiten Impuls am Ausgang $Q_1$ und $Q_2$ je eine logische « 1 » und nach dem dritten Impuls an allen Ausgängen $Q_1$ bis $Q_3$ je eine logische « 1 ». Durch eine Rückführung vom Ausgang $Q_3$ der letzten Stufe des Schieberegisters 38 zu dem NOR-Gatter 40 wechselt jetzt der Zustand am Ausgang des NOR-Gatter 40 von logisch « 1 » auf logisch « 0 ». Damit wird durch die folgenden Taktimpulse das logische Signal « 0 » in das Schieberegister 38 übernommen. Der Signalverlauf an den Ausgängen des Schieberegisters 38 entspricht wie aus Fig. 4 zu erkennen ist, dem bekannten Johnson-Code.

Mit den Ausgängen des Schrieberegisters 38 sind vier Gatter 41 bis 44 verbunden. Diese sind in Fig. 2 als Matrix wiedergegeben. Die Bedeutung dieser Darstellung ist in Fig. 3 oben erklärt. Die waagerechten Linien der Matrix stellen jeweils den Ausgang eines NOR-Gatters dar. Die senkrechten Linien sind mit den Ausgängen des Schieberegisters 38 verbunden. Jeweils an den mit einem Kreuz versehenen Stellen ist ein Eingang des jeweiligen NOR-Gatters mit dem betreffenden Ausgang des Schieberegisters 38 verbunden. Mittels der Gatter 41 bis 44 werden von den Ausgängen des Schieberegisters 38 Steuersignale abgeleitet, die während ganz bestimmter Zeiträume, die im folgenden mit Steuerintervalle bezeichnet werden, auftreten. Mit diesen Steuersignalen wird der programmartige, anhand von Fig. 1 schon beschriebene Übernahmevorgang gesteuert.

In Fig. 4 sind die verschiedenen Steuerintervalle von 0.) bis 5.) durchnummeriert. Rechts in Fig. 4 ist angegeben, welche Steuerfunktionen den einzelnen Steuerintervallen zugeordnet sind. Am Ausgang des Gatters 42 in Fig. 2 erscheint nur während des ersten Steuerintervalls das logische Signal « 0 ». Dieses wird mittels eines Inverters 45 in ein logisches Signal « 1 » umgewandelt und einem Eingang eines NOR-Gatters 27 zugeführt. Der Ausgang dieses NOR-Gatters 27 ist mit dem schon erwähnten Steuereingang 50 der untersten Stufe des Umlaufspeichers 30 verbunden. Das NOR-Gatter 27 ist damit nur während des ersten Steuerintervalls geöffnet. Dem anderen Eingang des NOR-Gatters 27 sind über eine Eingangsklemme 28 Taktimpulse 29 zugeführt, mit denen synchron zu der Steuerung des Umlaufspeichers 30 die Übernahme der erwähnten Bereichs-Information gesteuert wird. Das Signal am Ausgang des Inverters 45 steuert außerdem ein NOR-Gatter 36, auf das weiter unten näher eingegangen wird.

Am Ausgang des Gatters 44 erscheint vom ersten bis vierten Steuerintervall das logische Signal « 0 ». Dieses wird mittels eines Inverters 46 invertiert und einer Ausgangsklemme 47 zugeführt. Das Signal an der Ausgangsklemme 47 dient zur Sperrung der Auswerteschaltung 10 in Fig. 1 in der bei Fig. 1 schon beschriebenen Weise.

Vom Ausgang des Gatters 41 wird das NOR-Gatter 37, über das die Taktimpuls zu dem Schieberegister 38 übertragen werden, bei Erreichen der dem fünften Steuerintervall zugeordneten Schieberegister-Stellung blockiert, so daß das Schieberegister in der Stellung « 0 » « 0 » « 1 » verharrt. Wenn jetzt der Zustand am Ausgang des ODER-Gatters 22 von « 1 » auf « 0 » wechselt, so erhält der Reset-Eingang R das logische Signal « 1 », durch das alle Stufen des Schieberegisters 35 in die Ausgangsstellung « 0 » « 0 » « 0 » zurückgesetzt werden.

Um die Steuerung der Übernahme des Zählergebnisses des Zählers 8 in Fig. 1 in den Umlaufspeicher 30 zu verstehen, müssen zunächst andere Schaltungsteile der in Fig. 2 dargestellten Schaltung beschrieben werden. Die dem UKW-Bereich zugeordneten Eingangsklemmen 21 für die Kanal- und Frequenzanzeige sind mit einem NOR-Gatter 23 verbunden. Am Ausgang des NOR-Gatters 23 erscheint das logische Signal 0, wenn eine der UKW-Betriebsarten gewählt wird. Nur in diesem Fall soll die Übernahme des Zählergebnisses in den Umlaufspeicher 30 durchgeführt werden. Weiter soll die Übernahme nur erfolgen, wenn vor der Wahl einer UKW-Betriebsart die andere UKW-Betriebsart eingeschaltet war, d. h. wenn innerhalb des UKW-Bereiches die Betriebsart gewechselt wurde. Nur dann hat die Übernahme des Zählergebnisses in den Umlaufspeicher 30 einen Sinn. Aus diesem Grunde wird von einer Schaltung 31, in der die vorhergende Betriebsart als Teil der Bereichsinformation zunächst noch gespeichert ist, ein Signal abgeleitet, das dem logischen Zustand « 0 » entspricht, wenn der UKW-Bereich eingeschaltet ist bzw. war. Das von der Schaltung 31 abgeleitete Signal und das im NOR-Gatter 23 erzeugte Signal werden in einem NOR-Gatter 26 zusammengefaßt. Das NOR-

Gatter 26 bewirkt eine UND-Verknüpfung der von den Eingangsklemmen 21 und von dem Schaltungsteil 31 abgeleiteten Informationen. Am Ausgang des NOR-Gatters 26 erscheint damit ein Signal logisch « 1 » nur, wenn im UKW-Bereich von der Kanalanzeige auf die Frequenzanzeige oder umgekehrt gewechselt worden ist.

Der Ausgang des NOR-Gatters 26 ist mit dem Eingang eines getakteten 1-Bit-Speichers 35 verbunden. Der Speicher 35 wird von dem Taktsignal an der Klemme 55 über das NOR-Gatter 36 gesetzt. Das Taktsignal an der Klemme 55 kann das Gatter 36 nur passieren, wenn der untere Eingang des Gatters 36 sich im logischen Zustand « 0 » befindet. Dieses trifft für das erste Steuerintervall zu, in dem auch — wie schon beschrieben — die Bereichsinformation in den Umlaufspeicher 30 übernommen wird. Wenn am Ausgang des Gatters 26 das logische Signal « 1 » auftritt, so wird durch den im ersten Steuerintervall durchgelassenen Taktimpuls der Ausgang $\bar{Q}$ des Speichers 35 in den logischen Zustand « 0 » gebracht. Der Ausgang $\bar{Q}$ des Speichers 35 ist mit einem Eingang des als Matrix dargestellten Gatters 43 verbunden. Im vierten Steuerintervall des Schieberegisters 38 sind alle Eingänge des Gatters 43 im logischen Zustand « 0 », so daß am Ausgang des Gatters 43 der logische Zustand « 1 » auftritt. Der Ausgang des Gatters 43 ist über einen Inverter 159 mit einem Eingang eines NOR-Gatters 33 verbunden. Der Ausgang des NOR-Gatters 33 ist mit einem Steuereingang 53 der obersten Stufe des Umlaufspeichers 30 verbunden. An einem Eingang 54 der obersten Stufe des Umlaufspeichers 30 liegt das Ausgangssignal des Frequenzzählers 8 in Fig. 1. Am Eingang 54 erscheinen nacheinander die Stellen des im Frequenzzähler 8 gespeicherten Zählergebnisses. Über den Eingang 53 kann die Übernahme der Stellen in die oberste Stufe des Umlaufspeichers 30 gesteuert werden. Über eine Eingangsklemme 34 wird der obere Eingang des erwähnten NOR-Gatters 33 in jeder Multiplexphase (MPX genannt) des Umlaufspeichers 30 mit einem Impuls versehen. Da das Gatter 33 während des vierten Steuerintervalls, das der Dauer eines Umlaufzyklus des Umlaufspeichers 30 entspricht, geöffnet ist, gelangen fünf Impulse an den Steuereingang 53 des Umlaufspeichers 30. Durch diese wird das Zählergebnis Stelle für Stelle in den Umlaufspeicher 30 übernommen.

Mit dem nächsten Umlaufzyklus des Umlaufspeichers 30 wird das fünfte Steuerintervall des Schieberegisters 38 erreicht, in dem die Sperrung der Regelschleife der Gesamtschaltung wieder aufgehoben ist. Das Schieberegister verbleit in der dem fünften Steuerintervall zugeordneten Stellung bis der Reset-Eingang R in den logischen Zustand « 1 » wechselt.

Die über die Eingangsklemmen 55, 34 und 28 zugeführten Impulse werden ununterbrochen während der gesamten Betriebsdauer des Gerätes zugeführt. Ein Impuls besteht jeweils in einem kurzzeitigen Wechsel vom logischen Ruhezustand « 1 » in den Zustand « 0 ». Die Impulse werden durch die beschriebenen Gatter 36, 37, 33 und 27 jeweils für den Zeitraum, in dem sie gebraucht werden, durchgelassen. Die Impulse können mittels Frequenzteiler von einem in Fig. 1 nicht dargestellten Taktoszillator, der als Zeitbasis für den Frequenzzähler (8 in Fig. 1) dient, abgeleitet werden.

In Fig. 3 unten ist gezeigt, wie die Gatter 41 bis 44 in MOS-Technologie realisiert werden können. Der obere, mit der positiven Betriebsspannung $+U_B$ verbundene MOS-Transistor ist als Widerstand geschaltet.

In Fig. 5 ist der Inhalt der Schaltung 31 (Fig. 2) näher ausgeführt. Mit der obersten und zweitobersten Stufe des Umlaufspeichers 30 ist ein Zwischenspeicher 56 verbunden, der über eine Eingangsklemme 32 mit einem Steuertakt angesteuert wird. Der Zwischenspeicher 56 dient zur Speicherung der Bereichsinformation, die über die Eingangsklemmen 21 in Fig. 2 in den Umlaufspeicher 30 eingegeben wurde. Die Eingänge des Zwischenspeichers 56 sind mit denjenigen Stellen der obersten Stufen des Umlaufspeichers 30 verbunden, in denen die Bereichsinformation gespeichert ist. Jeweils in der Multiplex-Phase des Umlaufspeichers 30, in der die Bereichs-Information sich in den beiden obersten Stufen des Umlaufspeichers 30 befindet, wird der Steuereingang 32 des Zwischenspeichers 56 mit einem Steuertakt beaufschlagt. Aus dem Inhalt des Zwischenspeichers 56 wird mittels eines 1-aus-n-Decoders 57 die Bereichsinformation so abgeleitet, wie sie an den Eingangsklemmen 21 in Fig. 2 eingegeben wurde. Vom Ausgang des Decoders 57 werden die für die einzelnen Empfangs-Bereiche bzw. die Betriebsarten erforderlichen Umschaltungen im Frequenzzähler 8 in Fig. 1 gesteuert. Von denjenigen Ausgängen des Decoders 57, die dem UKW-Bereich zugeordnet sind, ist mittels eines NOR-Gatters 58 das schon bei Fig. 2 erwähnte Signal zur Steuerung des Gatters 26 abgeleitet. Das Ausgangssignal des Gatters 58 wird über eine Leitung 52 zum Gatter 26 geleitet.

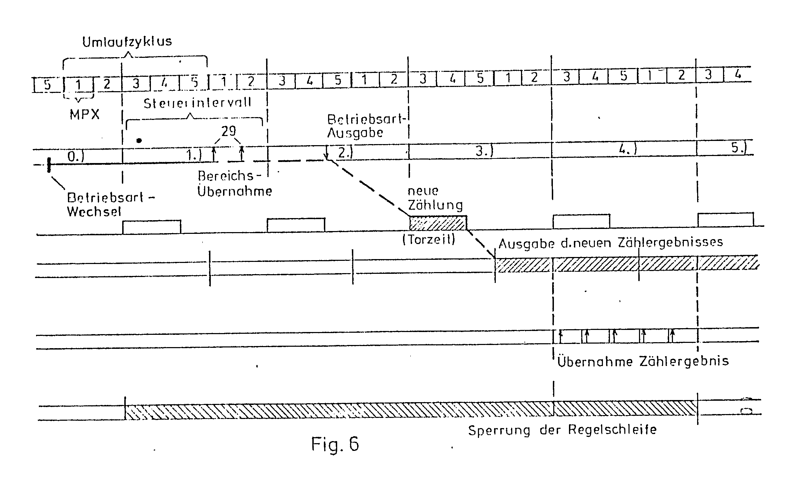

In Fig. 6 ist ein Zeitplan für den Steuerungsablauf der Schaltung nach Fig. 1 bzw. Fig. 2 gezeigt. Der der Eingangsklemme 55 in Fig. 2 zugeführte Impuls liegt jeweils zwischen der zweiten und dritten Multiplex-Phase (MPX) eines jeden Umlaufzyklus. Die Steuerintervalle der Schaltung nach Fig. 2 beginnen also jeweils mit der dritten Multiplex-Phase. Im ersten Steuerintervall werden von dem Gatter 27 in Fig. 2, wie in der zweiten Zeile der Fig. 6 dargestellt, zwei Impulse 29 zur Steuerung der Übernahme der Betreichsinformation in den Umlaufspeicher 30 durchgelassen. Im zweiten Steuerintervall gelangt die Bereichsinformation in den Zwischenspeicher 56 der Schaltung 31 in Fig. 2. Damit ist die geänderte Bereichswahl wirksam und steuert den Frequenzzähler 8, so daß die nächste Zählung im neuen Frequenz-Bereich bzw. in der neuen Betriebsart stattfindet. Kurz nach der Torzeit der neuen Zählung beginnt die Ausgabe des neuen Zählergebnisses, wie in der vierten Zeile in Fig. 6 dargestellt. In der fünften Zeile sind die im vierten Steuerintervall auftretenden Steuerimpulse am Steuereingang 53 des Umlaufspeichers 30 (Fig. 2) gezeigt, die die Übernahme des Zählergebnisses in den Umlaufspeicher 30 steuern. Mit dem Fünften Steuerintervall ist der Steuervorgang abgeschlossen. In der letzten Zeile ist gezeigt, während welcher Zeit an der Klemme 47 in Fig. 2 das schon erwähnte Sperrsignal auftritt.

Bei der anhand von Fig. 1 als Ausführungsbeispiel beschriebenen Schaltung wird das Zählergebnis des Frequenzzählers 8 als Empfangsfrequenz angezeigt. Es ist auch möglich, stattdessen den im Eingabeteil 7 gespeicherten Wert anzuzeigen. Es sind infolge der Nachregelung der Schaltung nur während vernachlässigbar kurzer Übergangszeiten Unterschiede zwischen den genannten Werten möglich.

**Ansprüche**

1. Automatische Abstimmschaltung mit einer Regelschleife für einen Hochfrequenz-Überlagerungsempfänger mit einem elektronischen Zähler (8) zur Bestimmung eines dem Empfangenen Sender zugeordneten Wertes durch periodisches Zählen der Schwingungen wenigstens eines Überlagerungsoszillators (6), mit einem Eingabespeicher (7, 30) zur Speicherung eines dem gewünschten Sender zugeordneten, manuell vorgegebenen Wertes, mit einem Vergleicher (9) zum Vergleich des Zählergebnisses des Zählers (8) mit dem Inhalt des Eingabespeichers (7, 30) und mit einer Auswertschaltung (10), die zur Auswertung des Vergleichsergebnisses den Ladestrom eines Kondensators (11) steuert und an ihm eine Abstimmspannung für den Überlagerungsoszillator (6) erzeugt, dadurch gekennzeichnet, daß der Zähler (8) zwischen zwei Betriebsarten, zur Zählung der der Empfangsfrequenz entsprechenden Überlagerungsfrequenz einerseits und zur Zählung der den Empfangskanälen entsprechenden Frequenzschritte, dieser Überlagerungsfrequenz andererseits umschaltbar ist, und daß für die Umschaltung innerhalb des gleichbleibenden Empfangsbereiches zur Aufrechterhaltung der Abstimmeinstellung eine Steuerschaltung (14) vorgesehen ist, mittels der nach einer Umschaltung des Zählers (8) von einer der Betriebsarten in die andere Betriebsart nach wenigstens einer Zählperiode in der neuen Betriebsart die Übernahme des neuen Zählergebnisses in den Eingabespeicher (7) gesteuert wird, um dem Vergleicher (9) wieder gleichartige Größen zuzuführen.

2. Abstimmschaltung nach Anspruch 1, dadurch gekennzeichnet, daß die Steuerschaltung ein getaktetes Schieberegister (38) und Gatter (41 bis 44) umfaßt und daß die Eingänge der Gatter (41 bis 44) so mit Ausgängen (Q, Q̄) des Schieberegisters (38) verbunden sind, daß an den Ausgängen der Gatter (41 bis 44) jeweils für die Dauer von den Stellungen des Schieberegisters (38) zugeordneten Steuerintervallen Steuersignale zur programmartigen Steuerung des Übernahmevorganges auftreten.

3. Abstimmschaltung nach Anspruch 2, dadurch gekennzeichnet, daß mittels eines ersten Gatters (42) von den Ausgängen des Schieberegisters (38) ein erstes Signal zur Steuerung der Aufnahme der gewählten Betriebsart in den Eingabespeicher (30) und mittels eines zweiten Gatters (43) ein zweites Signal zur Steuerung der Übernahme des neuen Zählergebnisses in den Eingabespeicher (30) abgeleitet werden und daß das erste (42) und zweite (43) Gatter so mit den Ausgängen des Schieberegisters (38) verbunden sind und die Taktsteuerung des Schieberegisters (38) so mit den Zählperioden des Zählers (8) synchronisiert ist, daß zwischen dem Auftreten des ersten und zweiten Signales wenigstens ein Zählzyklus des Zählers (8) in der geänderten Betriebsart liegt.

4. Abstimmschaltung nach Anspruch 2, dadurch gekennzeichnet, daß mittels eines dritten Gatters (44) von den Ausgängen des Schieberegisters (38) ein drittes Signal zur Sperrung der Regelschleife der Abstimmschaltung abgeleitet ist und daß das zweite Signal innerhalb des Zeitraumes des dritten Signales liegt.

5. Abstimmschaltung nach Anspruch 1, dadurch gekennzeichnet, daß der Empfänger Schaltmittel zur Einstellung gewünschter Empfangsbereiche und der Betriebsart des Zählers (8) aufweist und daß der Empfangsbereich und die Betriebsart im Eingabespeicher (30) speicherbar sind.

6. Abstimmschaltung nach Anspruch 5, dadurch gekennzeichnet, daß ein 1-Bit-Speicher (35) vorgesehen ist, dessen Steuereingang (E) über logische Gatter (23, 26, 58) oder dergleichen mit den Schaltmitteln einerseits und dem Eingabespeicher (30) andererseits so verknüpft ist, daß der 1-Bit-Speicher (35) gesetzt wird, wenn nur die Betriebsart gewechselt wird und der Empfangsbereich unverändert bleibt, und daß mit dem Ausgangssignal des 1-Bit-Speichers (35), das im gesetzten Zustand vorliegt, die Übernahme des Zählergebnisses in den Eingabespeicher (30) gesteuert wird.

7. Abstimmschaltung, bei der eine Umschaltung der Betriebsart des Zählers (8) nur in einem Empfangsbereich (UKW) vorgesehen ist, nach Anspruch 5, dadurch gekennzeichnet, daß zur Steuerung der Empfangsbereiche und der Betriebsarten des Zählers (8) vom Ausgang des Eingabespeichers (30) Signale im 1-aus-n-Code abgeleitet sind, wobei dem Empfangsbereich mit zwei Betriebsarten zwei Signale zugeordnet sind, daß mit dem Steuereingang (E) des 1-Bit-Speichers (35) der Ausgang eines UND-Verknüpfungsgliedes (NOR-Gatter 26) mit zwei Eingängen verbunden ist, daß der eine Eingang des UND-Verknüpfungsgliedes (26) mit dem Ausgang eines ersten ODER-Verknüpfungsgliedes (NOR-Gatter 58) verbunden ist, dem an zwei Eingängen die den beiden Betriebsarten des einen Empfangsbereiches (UKW) zugeordneten, vom Eingabespeicher (30) abgeleiteten Signale zugeführt sind, daß der andere Eingang des UND-Verknüpfungsgliedes (26) mit dem Ausgang eines zweiten ODER-Verknüpfungsgliedes (NOR-Gatter 23) verbunden ist, dem an zwei Eingängen den beiden Betriebsarten des einen Empfangsbereiches zugeordnete, von den Schaltmitteln abgeleitete Signale zugeführt sind.

8. Abstimmschaltung nach Anspruch 2, dadurch gekennzeichnet, daß mittels eines Gatters (43) von den Ausgängen des Schieberegisters (38) und einem Ausgang ($\bar{Q}$) des 1-Bit-Speichers (35) ein Signal zur Steuerung der Übernahme des Zählergebnisses in den Eingabespeicher (30) abgeleitet ist, wobei von dem logischen Zustand am Ausgang ($\bar{Q}$) des 1-Bit-Speichers (35) bestimmt wird, ob eine Übernahme stattfindet, und von dem Schieberegister (38), zu welchem Zeitpunkt ggf. diese Übernahme erfolgt.

9. Abstimmschaltung nach Anspruch 1, dadurch gekennzeichnet, daß der Eingabespeicher als Umlaufspeicher (30) ausgebildet ist, daß die Übernahme des Zählergebnisses stellenweise nacheinander jeweils parallel in eine Stufe des Umlaufspeichers (30) erfolgt, und daß an eine Stelle des Umlaufspeichers (30) ein stationärer Zwischenspeicher (56) angeschlossen ist, in dem durch Steuertakte die im Umlaufspeicher (30) befindliche Bereichs- und Betriebsart-Information übertragbar ist, daß an den Zwischenspeicher (56) ein 1-aus-n-Decoder (57) angeschlossen ist, dessen Ausgangssignale zur Steuerung des Frequenz-Zählers (8) und des 1-Bit-Speichern (35) dienen.

10. Abstimmschaltung nach Anspruch 1, dadurch gekennzeichnet, daß Mittel (10, 14, 16) vorgesehen sind, die während der Zeit der Übernahme des neuen Zählergebnisses in den Eingabespeicher (7) die Regelschleife der Abstimmschaltung sperren.

11. Abstimmschaltung nach Anspruch 10, dadurch gekennzeichnet, daß die Abstimminformation während der Zeit, in der die Regelschleife gesperrt ist, von einem Kondensator (11) gehalten wird.

**Claims**

1. An automatic tuning circuit with a control loop for a high-frequency heterodyne receiver with an electronic counter (8) for the determination of a value associated with the received transmitter by means of periodic counting of the oscillations of at least one heterodyning oscillator (6), with an input store (7, 30) for the storage of a manually predetermined value associated with the desired transmitter, with a comparator (9) for comparing the resulting count of the counter (8) with the content of the input store (7, 30) and with an evaluation circuit, which controls the charging current of a capacitor (11) for the evaluation of the result of the comparison and which produces a tuning voltage for the heterodyning oscillator (6), characterised in that the counter (8) is switchable between two modes of operation, for counting the heterodyne frequency corresponding to the reception frequency on the one hand, and on the other hand for counting the frequency steps of this heterodyne frequency corresponding to the reception channels, and that for the switching over within an unchanged reception range there is provided a control circuit (14) to maintain the tuning setting, by means of which circuit, after a switching over of the counter from one of the modes of operation to the other mode of operation and after at least one counting period in the new mode of operation, the transfer of the new resulting count to the input store (7) is controlled, in order to supply to the comparator (9) magnitudes which are again of the same kind.

2. A tuning circuit according to claim 1, characterised in that the control circuit comprises a pulsed shift register (38) and gates (41 to 44) and that the inputs of the gates (41 to 44) are so connected to the outputs (Q, $\bar{Q}$) of the shift register (38) that control signals for the programmed control of the transfer process appear at the outputs of the gates (41 to 44) in each case for the duration of the control intervals associated with the settings of the shift register (38).

3. A tuning circuit according to claim 2, characterised in that by means of a first gate (42) a first signal for the control of the initiation of the chosen mode of operation is fed from the outputs of the shift register (38) to the input store (30) and by means of a second gate (43) a second signal for the control of the transfer of the new resulting count to the input store (30), and that the first (42) and second (43) gates are so connected to the outputs of the shift register (38) and the pulse control of the shift register (38) is so synchronised with the counting periods of the counter 8, that at least one counting cycle of the counter (8) in the charged mode of operation lies between the appearance of the first and the second signals.

4. A tuning circuit according to claim 2, characterised in that by means of a third gate (44) a third signal for blocking the control loop of the tuning circuit is derived from the outputs of the shift register (38) and that the second signal lies within the period of the third signal.

5. A tuning circuit according to claim 1, characterised in that the receiver has switching means for setting the desired reception ranges and the mode of operation of the counter (8) and that the reception range and the mode of operation can be stored in the input store (30).

6. A tuning circuit according to claim 5, characterised in that a 1-bit-store (35) is provided, of which the control input (E) is so connected via logic gates (23, 26, 58) or the like to the switching means on the one hand, and on the other hand to the input store (30) that the 1-bit-store (35) is set when only the mode of operation is changed and the reception range remains unaltered, and that the transfer of the resulting count to the input store (30) is controlled by the output signal of the 1-bit-store (35) which is in the set condition.

7. A tuning circuit, in which a switching over of the mode of operation of the counter (8) is provided only in one reception range (UKW) according to claim 5, characterised in that to control the reception range and the mode of operation of the counter (8) signals in 1-from-n code are derived from the output of the input store (30), two signals being associated with the reception range with two modes of operation, that the output of an AND logic element (NOR-gate 26) with two inputs is connected to the control input (E) of the 1-bit-store (35), that a first input of the AND logic element (26) is connected to the output of a first OR logic element (NOR-gate 58) to which are supplied at two inputs the signals derived from the input store (30) which are associated with the two modes of operation of said one reception range (UKW), that the other input of the AND logic element (26) is connected to the output of a second OR logic element (26) is connected to the output of a second OR logic element (NOR-gate 23), to which are supplied at two inputs signals derived from the switching means which are associated with the two modes of operation of said one reception range.

8. A tuning circuit according to claim 2, characterised in that by means of a gate (43) a signal for the control of the transfer of the resulting count to the input store (3) is derived from the outputs of the shift register (38) and an output ($\bar{Q}$) of the 1-bit-store (35), it being determined from the logical condition of the output ($\bar{Q}$) of the 1-bit-store whether a transfer is taking place, and from the shift register (38) at which point in time this transfer, if any, occurs.

9. A tuning circuit according to claim 1, characterised in that the input store is contructed as a circulating store, that the transfer of the resulting count occurs successively with regard to position and in each case parallel into a stage of the circulating store (30), and that to one point of the circulating store (30) there is connected a stationary temporary store (56) into which the information in the circulating store (30) concerning range and mode of operation can be transferred by means of control pulses, that a 1-from-n decoder (57) is connected to the temporary store (56), the output signals of the decoder serving to control the frequency counter (8) and the 1-bit-store (35).

10. A tuning circuit according to claim 1, characterised in that means (10, 14, 16) are provided, which, during the time of the transfer of the new resulting count to the input store (7), block the control loop of the tuning circuit.

11. A tuning circuit according to claim 10, characterised in that the tuning information is held by a capacitor (11) during the time in which the control loop is blocked.

**Revendications**

1. Circuit d'accord automatique avec une boucle de régulation pour un récepteur superhétérodyne haute fréquence, comprenant un compteur électronique (8) pour détermination d'une valeur affectée à l'émetteur reçu par comptage périodique des oscillations d'au moins un oscillateur local (6), une mémoire d'entrée (7, 30) pour le stockage d'une valeur prédéterminée manuellement et affectée à l'émetteur souhaité, un comparateur (9) du résultat du compteur (8) et du contenu de la mémoire d'entrée (7, 30), et un circuit traducteur (10) qui, pour la traduction du résultat de la comparaison, commande le courant de charge d'un condensateur (11) aux bornes duquel il produit une tension d'accord de l'oscillateur local (6), ledit circuit d'accord étant caractérisé en ce que le compteur (8) est commutable entre deux modes de fonctionnement, pour le comptage de la fréquence de battement correspondant à la fréquence de réception d'une part et le comptage des pas de cette fréquence de battement correspondant aux canaux de réception d'autre part ; et un circuit de commande (14) est prévu pour la commutation sur une même gamme de réception avec maintien du réglage de l'accord, et commande le transfert du nouveau résultat de comptage dans la mémoire d'entrée (7) après une commutation du compteur (8) d'un des modes de fonctionnement dans l'autre et au moins une période de comptage dans le nouveau mode, afin que des grandeurs identiques soient de nouveau transmises au comparateur (9).

2. Circuit d'accord selon revendication 1, caractérisé en ce que le circuit de commande comprend un registre à décalage cadencé (38) et des opérateurs (41 à 44) ; et les entrées des opérateurs (41 à 44) sont reliées à des sorties (Q, $\bar{Q}$) du registre à décalage (38) de façon que des signaux de commande programmée de l'opération de transfert apparaissent sur les sorties des opérateurs (41 à 44), pendant la durée d'intervalles de commande affectés aux positions du registre à décalage (38).

3. Circuit d'accord selon revendication 2, caractérisé en ce qu'un premier opérateur (42) dérive des sorties du registre à décalage (38) un premier signal de commande du transfert du mode de fonctionnement sélecté dans la mémoire d'entrée (30) et un second opérateur (43) dérive un second signal de commande du transfert du nouveau résultat de comptage dans la mémoire d'entrée (30) ; et le premier (42) et le second (43) opérateur sont reliés aux sorties du registre à décalage (38) et la commande impulsionnelle du registre à décalage (38) est synchronisée avec les périodes de comptage du compteur (8) de façon qu'un cycle de comptage au moins du compteur (8) dans le mode de fonctionnement modifié sépare l'apparition du premier et du second signal.

4. Circuit d'accord selon revendication 2, caractérisé en ce qu'un troisième opérateur (44) dérive des sorties du registre à décalage (38) un troisième signal de blocage de la boucle de régulation du circuit d'accord ; et le second signal se situe dans l'intervalle de temps du troisième signal.

5. Circuit d'accord selon revendication 1, caractérisé en ce que le récepteur comporte des moyens de commutation pour le réglage des gammes de réception souhaitées et du mode de fonctionnement du compteur (8) ; et la gamme de réception et le mode de fonctionnement peuvent être stockés dans la mémoire d'entrée (30).

6. Circuit d'accord selon revendication 5, caractérisé en ce qu'un mémoire de 1 bit (35) est prévue, dont l'entrée de commande (E) est combinée par les opérateurs logiques (23, 26, 58) ou autres avec les moyens de commutation d'une part et la mémoire d'entrée (30) d'autre part, de façon que la mémoire de 1 bit (35) soit remise à 0 quand seul le mode de fonctionnement est modifié, la gamme de réception demeurant inchangée ; et le signal de sortie de la mémoire de 1 bit (35) présent dans l'état remis à 1, commande le transfert du résultat du compteur dans la mémoire d'entrée (30).

7. Circuit d'accord dans lequel une commutation du mode de fonctionnement du compteur (8) est prévue uniquement sur une gamme de réception (FM) selon revendication 5, caractérisé en ce que des signaux sont dérivés en code « 1 parmi n » de la sortie de la mémoire d'entrée (30) pour la commande des gammes de réception et des modes de fonctionnement du compteur (8), deux signaux étant affectés à la gamme de réception à deux modes de fonctionnement ; l'entrée de commande (E) de la mémoire de 1 bit (35) est reliée à la sortie d'un opérateur ET (opérateur NI 26) à deux entrées ; une entrée de l'opérateur ET (26) est reliée à la sortie d'un premier opérateur OU (opérateur NI 58), dont deux entrées reçoivent les signaux dérivés de la mémoire d'entrée (30) et affectés aux deux modes de fonctionnement d'une gamme de réception (FM) ; et l'autre entrée de l'opérateur ET (26) est reliée à la sortie d'un second opérateur OU (opérateur NI 23), dont deux entrées reçoivent les signaux dérivés des moyens de commutation et éffectés aux deux modes de fonctionnement d'une gamme de réception.

8. Circuit d'accord selon revendication 2, caractérisé en ce qu'un opérateur (43) dérive des sorties du registre à décalage (38) et d'une sortie (Q̄) de la mémoire de 1 bit (35) un signal de transfert du résultat du compteur dans la mémoire d'entrée (30), l'état logique de la sortie (Q̄) de la mémoire de 1 bit (35) déterminant si un transfert doit s'effectuer et le registre à décalage (38) l'instant de ce transfert.

9. Circuit d'accord selon revendication 1, caractérisé en ce que la mémoire d'entrée est réalisée sous forme de mémoire circulaire (30) ; le transfert du résultat du compteur s'effectue rang par rang, en parallèle dans un étage de la mémoire circulaire (30) ; un rang de la mémoire circulaire (30) est relié à une mémoire temporaire stationnaire (56), dans laquelle des impulsions de commande transmettent l'information de gamme et de mode de fonctionnement se trouvant dans la mémoire circulaire (30) ; et la mémoire temporaire (56) est reliée à un décodeur « 1 parmi n » (57), dont les signaux de sortie commandent le compteur de fréquence (8) et la mémoire de 1 bit (35).

10. Circuit d'accord selon revendication 1, caractérisé par des moyens (10, 14, 16) qui bloquent la boucle de régulation du circuit d'accord pendant la durée du transfert du nouveau résultat du compteur dans la mémoire d'entrée (7).

11. Circuit d'accord selon revendication 10, caractérisé en ce que l'information d'accord est maintenue par un condensateur (11) pendant la durée de blocage de la boucle de régulation.

0 014 724

Fig.1

Fig. 2

1 Impuls pro Zyklus
1 Impuls pro MPX
Takt
Eingabe-Takt
vom Zähler
Sperr-signal
Umlauf-Speicher
30
Codierer
24
Matrix
Taktimpulse 29
UKW
Kan.
Frequ.
MW
LW
KW
0 014 724

Fig. 3

Stellung des Schieberegisters

| Steuerintervall | $Q_1$ $Q_2$ $Q_3$ | |
|---|---|---|
| 0.) | 0 0 0 | |
| 1.) | 1 0 0 | } Übernahme Betriebsart |
| 2.) | 1 1 0 | |
| 3.) | 1 1 1 | } Vergleichs-Sperrung |
| 4.) | 0 1 1 | } Übernahme Zählergebnis |
| 5.) | 0 0 1 | |

Fig. 4

Fig. 5

Fig. 6